Europäisches Patentamt

European Patent Office

Office européen des brevets

(11) Numéro de publication: **0 324 292**
**A1**

## DEMANDE DE BREVET EUROPEEN

(21) Numéro de dépôt: 88403166.7

(22) Date de dépôt: 13.12.88

(51) Int. Cl.⁴: **G01R 33/02**

(30) Priorité: 16.12.87 FR 8717566

(43) Date de publication de la demande:
19.07.89 Bulletin 89/29

(84) Etats contractants désignés:
**DE GB NL**

(71) Demandeur: **COMMISSARIAT A L'ENERGIE ATOMIQUE**
**31/33, rue de la Fédération**
**F-75015 Paris(FR)**

(72) Inventeur: **Crescini, Jean**
**26, rue de Montroux**
**F-38420 Domene(FR)**
Inventeur: **Duret, Denis**
**13, rue de Stalingrad**
**F-38100 Grenoble(FR)**

(74) Mandataire: **Mongrédien, André et al**
**c/o BREVATOME 25, rue de Ponthieu**
**F-75008 Paris(FR)**

(54) **Magnétomètre vectoriel continu à capteur capacitif magnétostrictif et gradientmètre comportant application de ce capteur.**

(57) Magnétomètre vectoriel continu à capteur magnétostrictif comprenant un capteur capacitif (10) qui contient une capacité dont l'une au moins des armatures est constituée d'un matériau ayant des propriétés magnétostrictives, et des moyens de mesure (12) de la variation de capacité dudit capteur capacitif (10) sous l'action d'un champ magnétique extérieur.

L'invention a aussi pour objet un gradientmètre comportant application de deux capteurs capacitifs du type de ceux utilisés dans un magnétomètre.

Application à la mesure de champs magnétiques continus ou lentement variables pour le magnétomètre, mesure d'un gradient de champ magnétique pour le gradientmètre.

FIG. 4

# MAGNETOMETRE VECTORIEL CONTINU A CAPTEUR CAPACITIF MAGNETOSTRICTIF ET GRADIENTME-TRE COMPORTANT APPLICATION DE CE CAPTEUR

La présente invention a pour objet un magnétomètre vectoriel continu à capteur capacitif magnétostrictif et un gradientmètre comportant application de ce capteur. Elle s'applique notamment à la mesure d'un champ magnétique en un point suivant une direction donnée pour le magnétomètre et à la mesure différentielle d'un champ magnétique suivant une direction entre deux points, les champs appliqués sur ces points pouvant avoir une orientation quelconque, pour le gradientmètre.

Différents types de magnétomètre sont bien connus et fonctionnent suivant des procédés divers. On en rappelle ici les principales caractéristiques connues.

Les magnétomètres à déviation de porteurs utilisant des semi-conducteurs ont une résolution médiocre ($10^{-5}$ T), ils ne sont adaptés qu'à la mesure de champs forts.

Les magnétomètres à induction sont simples et performants mais ils ne permettent pas de mesurer des variations lentes du champ magnétique.

Les magnétomètres à supraconducteur ont une excellente résolution ($10^{-14}$ T) mais ils ne fonctionnent qu'à basse température et ils ne sont pas absolus.

Les magnétomètres "flux gate" fonctionnent par saturation d'un matériau ferromagnétique non rémanent. Leur résolution est bonne ($10^{-11}$T) mais ils sont sujets à dérives et leur consommation est importante.

Un exemple de magnétomètre à magnétostriction est décrit dans l'article de Mermelstein et Dandridge : "low-frequency magnetic field detection with a magnetostrictive amorphous metal ribbon", paru dans la revue Applied Physics Letters n° 51, volume n° 7, page 545, en août 1987. On rappelle qu'un matériau magnétostrictif est un matériau dont la déformation mécanique accompagne l'aimantation.

Un métal magnétostrictif est couplé à une plaque résonnante en céramique par l'intermédiaire d'un matériau à grande viscosité. La structure est excitée par la céramique à la fréquence de résonance de cette dernière. Le moment magnétique du métal possède une composante à cette fréquence qui module celle du champ magnétique statique à mesurer. Par ce moyen, une tension aux bornes d'un bobinage de prélèvement est induite. Si la résolution de ce magnétomètre est bonne ($10^{-11}$ T), il est très sensible aux parasites induits.

Le magnétomètre à fibre optique est décrit dans les articles de Yariv et Winsor "Proposed for detection of magnetic fields through magnetostrictive perturbation of optical fibers" paru en 1980 dans la revue Optic letters n° 5, page 87, et de Koo, Bucholtz, Dandridge et Tveten "Stability of a fiber optic magnetometer using metallic glass" paru en 1986 dans la revue IEEE trans. magnet., volume MAG-22, page 141.

Un matériau magnétostrictif est collé à une fibre optique dont on mesure à la fois les variations d'indice et d'allongement. Cette fibre fait partie d'un interféromètre optique excité par un laser. La mesure de la différence de phase induite est reliée à la mesure du champ magnétique.

La résolution de ce dispositif est de l'ordre de $10^{-9}$T.

Cette technique est difficile à mettre en oeuvre, son industrialisation est donc problématique ; d'autre part, sa consommation électrique est élevée, enfin l'encombrement de ce système est important.

Tous les magnétomètres décrits ci-dessus présentent des inconvénients que la présente invention permet de pallier. Elle préconise l'utilisation d'un capteur capacitif ayant une de ses armatures en matériau magnétostrictif et d'un système de mesure des variations de la capacité sous l'effet d'un champ magnétique. Ces variations étant dues aux déformations du matériau magnétostrictif sous l'action d'un champ magnétique.

Ce dispositif permet la mesure absolue de faibles champs magnétiques continus ou à variations lentes dans une direction donnée.

La résolution du dispositif est bonne ($10^{-9}$T dans son usage courant) et d'autre part, il n'est pas sujet à la dérive grâce à une contre-réaction contenue dans les moyens de mesure des variations de la capacité du capteur capacitif.

La consommation électrique du dispositif selon l'invention est faible, les moyens de mesure contenant principalement des circuits intégrés de faible consommation.

Le dispositif est peu sensible aux parasites induits, le capteur capacitif étant contenu dans une enveloppe blindée électriquement (corps métallique conducteur mis à la masse). En dernier lieu, le présent dispositif n'est que peu encombrant.

De manière plus précise, la présente invention a pour objet un magnétomètre vectoriel continu à capteur magnétostrictif, comprenant :
- un capteur capacitif comportant au moins :
- une première armature conductrice de l'électricité,
- une seconde armature conductrice de l'électricité,
- un matériau diélectrique interposé entre la première et la seconde armatures,
l'une au moins de ces armatures étant en matériau magnétostrictif,

- une bobine de modulation et de contre-réaction,

ce capteur capacitif étant connecté à des moyens de mesure mesurant la variation de capacité dudit capteur capacitif sous l'action d'un champ magnétique extérieur, ces moyens de mesure comprenant :

- un pont de mesure de capacité, relié au capteur capacitif par une liaison coaxiale C1 et délivrant un signal sur une sortie Sp,

- un démodulateur synchrone, relié par une entrée Ed1 à la sortie Sp du pont de mesure et par une entrée Ed2 à la sortie So d'un oscillateur de modulation, et délivrant un signal Vds sur une sortie Sd,

- un intégrateur relié par une entrée Ei à la sortie Sd du démodulateur synchrone et délivrant sur une sortie Si un signal Vs proportionnel audit champ magnétique extérieur,

- un additionneur ayant une entrée Ea1 connectée par l'intermédiaire d'un interrupteur I à la sortie Si de l'intégrateur, et ayant une entrée Ea2 reliée à la sortie So de l'oscillateur de modulation, et délivrant un signal sur une sortie Sa,

- un convertisseur tension/courant relié par une entrée Ec à la sortie Sa de l'additionneur et délivrant un signal sur une sortie Sc, la sortie Sc dudit convertisseur étant reliée par un cable coaxial C2 au capteur capacitif.

Selon une variante de réalisation, chacune des armatures est composée par un matériau magnétostrictif, le matériau magnétostrictif composant la première armature ayant des caractéristiques opposées aux caractéristiques magnétostrictives du matériau magnétostrictif composant la seconde armature.

De manière préférée, ledit capteur capacitif comprend en outre un blindage externe relié à la masse.

De manière préférée, ledit capteur capacitif est de forme cylindrique.

La forme cylindrique du capteur capacitif permet une bonne définition de la direction de mesure et une insensibilité aux champs radiaux. Le fait que le capteur capacitif soit enfermé dans une enveloppe métallique à la masse permet aussi l'étanchéité du magnétomètre.

L'invention a aussi pour objet un gradientmètre comportant application du capteur capacitif pour la mesure d'une différence de champs magnétiques H1-H2, comprenant :

- deux capteurs capacitifs C10, C'10 sur lesquels sont appliqués respectivement les champs H1 et H2 dont la différence est à mesurer,

- des moyens de mesure de la différence de champs magnétiques H1-H2,

- deux générateurs de courant G1, G2 permettant une création d'une différence de champ de contre-réaction entre les capteurs capacitifs C10, C'10 ;

les capteurs capacitifs sont reliés aux moyens de mesure par des câbles coxiaux C1, C3, un câble coxial C2 reliant les moyens de mesure à un capteur capacitif C10 par l'intermédiaire d'un générateur de courant G1 et reliant les moyens de mesure à l'autre capteur capacitif C'10 par l'intermédiaire de l'autre générateur de courant G2.

Selon un mode préféré de réalisation du gradientmètre, les capteurs capacitifs C10, C'10 ont une armature commune.

La réalisation d'un gradientmètre selon l'invention permet de n'utiliser qu'une seule électronique de mesure. D'autre part, le passage du magnétomètre au gradientmètre ne nécessite que peu de changements dans les moyens de mesure, il est donc aisé de passer de l'un à l'autre.

D'autres caractéristiques et avantages de l'invention ressortiront mieux de la description qui va suivre, donnée à titre purement illustratif et nullement limitatif, en référence aux figures annexées dans lesquelles :

- la figure 1 représente le schéma général d'un dispositif selon l'invention,

- la figure 2 représente le schéma d'un mode de réalisation d'un capteur capacitif selon l'invention,

- la figure 3 représente le schéma d'un autre mode de réalisation d'un capteur capacitif selon l'invention,

- la figure 4 représente le schéma synoptique d'un dispositif selon l'invention,

- la figure 5 représente le signal de réponse du capteur après démodulation synchrone par rapport au champ magnétique extérieur H,

- la figure 6 représente le schéma synoptique d'un mode de réalisation d'un gradientmètre selon l'invention,

- la figure 7 représente les capteurs utilisés dans un gradientmètre, dans une conformation particulière de l'invention.

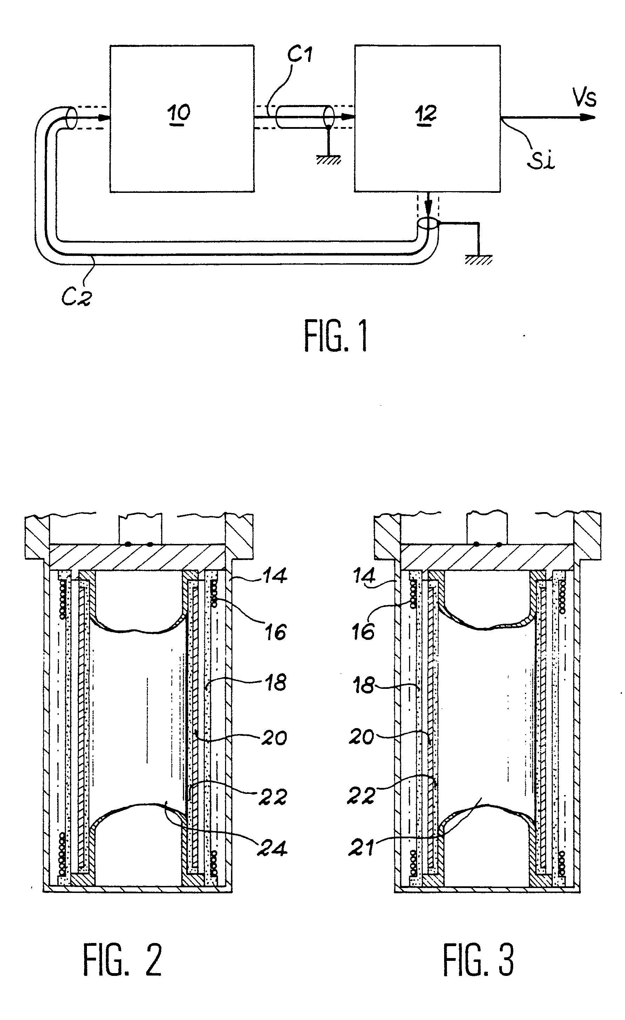

Sur la figure 1, on voit qu'un dipositif selon l'invention comporte un capteur capacitif 10 qui contient une capacité dont l'une au moins des armatures est constituée d'un matériau ayant des propriétés magnétostrictives. Le capteur 10 est relié par des câbles coaxiaux C1, C2 à des moyens de mesure 12 de la valeur de la capacité du capteur 10. Ces moyens de mesure 12 délivrent sur une sortie Si une tension Vs proportionnelle au champ magnétique. Le capteur capacitif 10 est dans un premier temps étalonné par application de champs magnétiques connus. Le coefficient de proportionnalité entre la tension Vs et le champ à mesurer en est déduit.

Sur la figure 2, on voit un capteur capacitif selon l'invention. Ledit capteur est cylindrique et il comprend :

- un blindage externe 14 relié à la masse, il s'agit là d'une enveloppe métallique,
- une bobine 16 de modulation et de contre-réaction dont l'utilité est mise en évidence plus loin,
- un support 18 de la bobine,
- un matériau magnétostrictif 20, - un diélectrique 22, un ruban d'épaisseur 100 μm de polyimide, par exemple,
- une armature métallique 24.

La variation d'épaisseur avec l'application d'un champ magnétique externe du matériau magnétostrictif 20 entraîne une variation de la valeur de la capacité formée par le matériau magnétostrictif 20, le diélectrique 22, l'armature métallique 24. Le matériau magnétostrictif est choisi parmi les matériaux magnétiques amorphes tels les verres métalliques. En particulier, le Metglas (R) de type 2605-S2 fabriqué par la firme Allied Corporation convient.

La figure 3 représente un mode de réalisation d'un capteur capacitif. La différence entre ce capteur et celui décrit précédemment figure 2 consiste en ce que l'armature métallique 24 est remplacée par une armature en matériau magnétostrictif 21 dont les caractéristiques de magnétostriction sont de nature opposée à celles du matériau magnétostrictif 20 constituant l'autre armature.

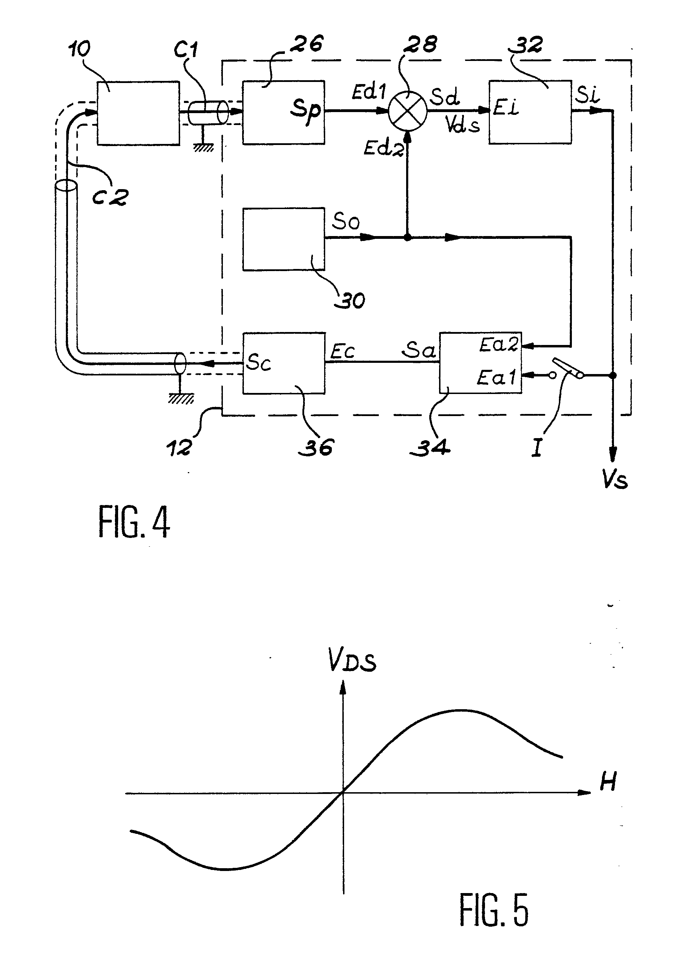

La figure 4 représente un schéma synoptique d'un magnétomètre selon l'invention. Le capteur capacitif 10 est relié aux moyens de mesure 12 par un câble coaxial C1. Ce câble C1 est en fait relié à un pont de mesure de capacité 26 qui délivre sur une sortie Sp un signal. Une entrée Ed1 d'un démodulateur synchrone 28 est reliée à la sortie Sp. Une autre entrée Ed2 du démodulateur synchrone est reliée à une sortie 30 d'un oscillateur de modulation 30. Le démodulateur synchrone 28 délivre un signal Vds sur une sortie Sd. Cette sortie Sd est reliée à l'entrée Ei d'un circuit intégrateur 32 qui délivre sur une sortie Si une tension Vs. A cette sortie Si est reliée une entrée Ea1 d'un circuit additionneur 34 par l'intermédiaire d'un interrupteur I. Une entrée Ea2 du circuit additionneur 34 est reliée à la sortie So de l'oscillateur de modulation. Le circuit additionneur 34 délivre un signal sur une sortie Sa reliée à l'entrée Ec d'un circuit 36 convertisseur de tension en courant. Ce circuit convertisseur 36 délivre un signal sur une sortie Sc et est relié par un câble coaxial C2 au capteur capacitif 10.

Le signal délivré par le pont de mesure 26 est modulé par l'oscillateur de modulation 30. Ce dernier est en fait relié à la bobine de modulation et de contre-réaction 16. Le champ induit par cette bobine module les variations d'épaisseurs du matériau magnétostrictif formant une armature du capteur capacitif. On élimine par la démodulation des parasites perturbant la mesure.

On voit sur la figure 5 que le signal Vds délivré sur la sortie Sd du démodulateur synchrone 28 est linéaire, en fonction des variations du champ magnétique extérieur autour de zéro. Mais des fluctuations extérieures au système peuvent faire varier de manière incontrôlée la pente de cette partie linéaire de la courbe et donc le coefficient de proportionnalité entre Vds et le champ magnétique.

On introduit donc une contre-réaction qui maintient la tension Vds à zéro. Cette contre-réaction est constituée principalement par l'intégrateur 32 et l'interrupteur I. La sortie Si de l'intégrateur 32 délivre une tension Vs qui, l'interrupteur I étant fermé, permettra, après sa conversion en courant par le convertisseur tension-courant 36, d'induire dans la bobine 16 de modulation et contre-réaction un champ magnétique opposé au champ magnétique extérieur. La tension Vs nécessaire pour maintenir Vds à zéro est donc proportionnelle au champ magnétique extérieur.

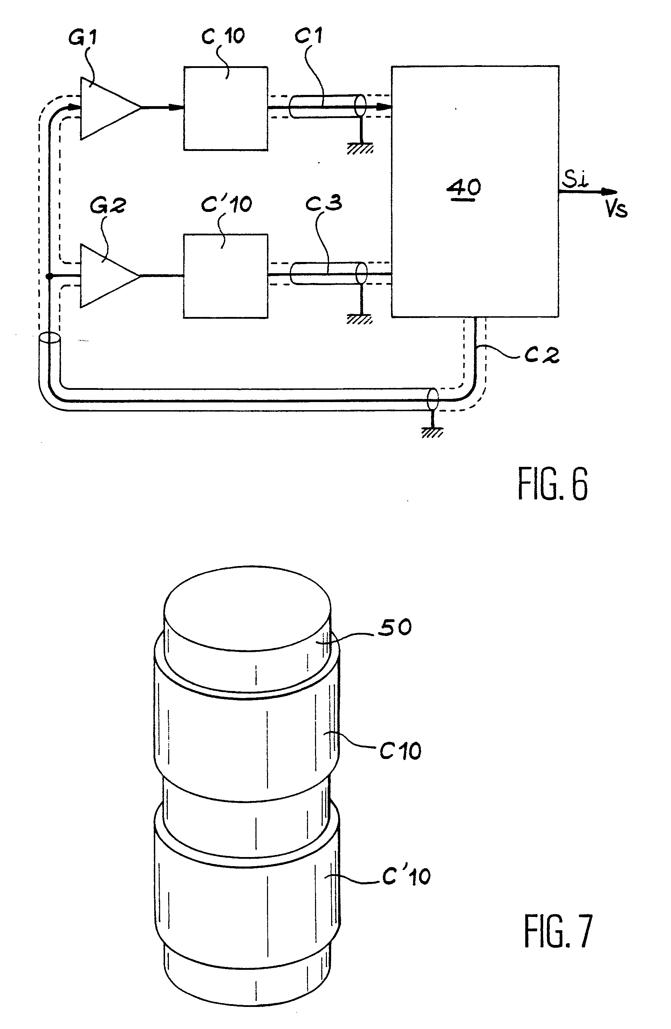

La figure 6 représente le schéma général d'un gradientmètre selon l'invention.

Le gradientmètre comprend deux capteurs capacitifs C10, C'10, tels que décrits précédemment à savoir qu'ils ont tous deux une armature au moins en matériau magnétostrictif. Chaque capteur C10, C'10 est relié par des cables coaxiaux C1, C3 à des moyens de mesure 40 de la différence de champ appliqué sur les capteurs C10, C'10. Ces moyens de mesure 40 délivrent une tension Vs sur une sortie Si. La tension Vs est proportionnelle à la différence de champ appliquée entre les deux capteurs C10, C'10.

Les moyens de mesure 40 sont reliés par un câble coxial C2 aux deux capteurs C10, C'10 par l'intermédiaire de générateurs de courant G1 et G2.

Le fonctionnement des moyens de mesure 40 est sensiblement le même que dans le cas du magnétomètre. Les deux capteurs C10, C'10 sont inclus dans un pont de mesure. Le pont de mesure délivre une tension qui est modulée par un oscillateur de modulation et démodulée par un démodulateur synchrone. La courbe représentant les variations de la tension en sortie du démodulateur synchrone en fonction d'une différence de champ magnétique appliquée sur les capteurs C10, C'10 présente une partie linéaire. La pente de cette partie linéaire varie sous l'influence de fluctuations extérieures incontrôlables. Une contre-réaction permettant d'induire un gradient de champ magnétique opposé au gradient de champ magnétique à mesurer entre les deux capteurs C10, C'10 est appliquée par un circuit intégrateur et les deux générateurs de courant G1, G2. Par ce moyen, la tension en sortie du démodulateur synchrone est constamment maintenue à zéro. La tension délivrée en sortie de l'intégrateur est celle qu'on retrouve sur la sortie Si des moyens de mesure ; elle est proportionnelle à la différence de champs magnétiques extérieurs.

Sur la figure 7, on voit un mode de réalisation de l'invention particulièrement adapté à la mesure d'un gradient entre deux champs magnétiques ayant même direction. Les deux capteurs capacitifs C10, C'10 comportent une armature 50 commune. Dans le cas d'un capteur cylindrique, il s'agit de l'armature centrale, les autres composants des capteurs s'enroulant autour.

## Revendications

1. Magnétomètre vectoriel continu à capteur magnétostrictif, caractérisé en ce qu'il comprend :
- un capteur capacitif (10) comportant au moins :
- une première armature conductrice de l'électricité,
- une seconde armature conductrice de l'électricité,
- un matériau diélectrique (22) interposé entre la première et la seconde armatures,
l'une au moins de ces armatures étant en matériau magnétostrictif,
- une bobine (16) de modulation et de contre-réaction, ce capteur capacitif (10) étant connecté à des moyens de mesure (12) mesurant la variation de capacité dudit capteur capacitif (10) sous l'action d'un champ magnétique extérieur, ces moyens de mesure (12) comprenant :
- un pont de mesure de capacité (26), relié au capteur capacitif (10) par une liaison coaxiale C1 et délivrant un signal sur une sortie Sp,
- un démodulateur synchrone (28), relié par une entrée Ed1 à la sortie Sp du pont de mesure (26) et par une entrée Ed2 à la sortie So d'un oscillateur de modulation (30), et délivrant un signal Vds sur une sortie Sd,
- un intégrateur (32) relié par une entrée Ei à la sortie Sd du démodulateur synchrone (28) et délivrant sur une sortie Si un signal Vs proportionnel audit champ magnétique extérieur,
- un additionneur (34) ayant une entrée Ea1 connectée par l'intermédiaire d'un interrupteur I à la sortie Si de l'intégrateur (32), et ayant une entrée Ea2 reliée à la sortie So de l'oscillateur de modulation (30), et délivrant un signal sur une sortie Sa,
- un convertisseur (36) tension/courant relié par une entrée Ec à la sortie Sa de l'additionneur (34) et délivrant un signal sur une sortie Sc, la sortie Sc dudit convertisseur (36) étant reliée par un câble coaxial C2 au capteur capacitif (10).

2. Magnétomètre selon la revendication 1, caractérisé en ce que chacune des armatures est composée par un matériau magnétostrictif, le matériau magnétostrictif composant la première armature ayant des caractéristiques opposées aux caractéristiques magnétostrictives du matériau magnétostrictif composant la seconde armature.

3. Magnétomètre selon la revendication 1, caractérisé en ce que ledit capteur capacitif (10) comprend en outre un blindage externe (14) relié à la masse.

4. Magnétomètre selon la revendication 1, caractérisé en ce que ledit capteur capacitif (10) est de forme cylindrique.

5. Gradientmètre comportant application de capteurs capacitifs tels que décrits dans l'une quelconque des revendications 1 à 4 pour la mesure d'une différence de champs magnétiques H1-H2, caractérisé en ce qu'il comprend :
- deux capteurs capacitifs C10, C'10 sur lesquels sont appliqués respectivement les champs H1 et H2 dont la différence est à mesurer,
- des moyens de mesure (12) de la différence de champs magnétiques H1-H2,
- deux générateurs de courant G1, G2 permettant une création d'une différence de champ de contre-réaction entre les capteurs capacitifs C10, C'10,
et en ce que les capteurs capacitifs sont reliés aux moyens de mesure (40) par des câbles coaxiaux C1, C3, un cable coaxial C2 reliant les moyens de mesure (40) à un capteur capacitif C10 par l'intermédiaire d'un générateur de courant G1 et reliant les moyens de mesure (40) à l'autre capteur capacitif C'10 par l'intermédiaire de l'autre générateur de courant G2.

6. Gradientmètre selon la revendication 5, caractérisé en ce que les capteurs capacitifs C10, C'10 ont une armature commune (50).

**FIG. 1**

**FIG. 2**

**FIG. 3**

FIG. 4

FIG. 5

FIG. 6

Si
Vs

G1  C 10  C1  40

G2  C'10  C3

C2

FIG. 7

50

C 10

C'10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 092 371 (K.K. TOSHIBA) <br> * Résumé * <br> --- | 1 | G 01 R 33/02 |
| A | JAPANESE JOURNAL OF APPLIED PHYSICS, vol. 21, no. 10, partie 1, octobre 1982, pages 1527-1528, Tokyo, JP; S. YOSHINO et al.: "Measurement of magnetostriction of amorphous Dy-Fe films by cantilever capactiance method" <br> * Colonne 1, lignes 1-42; figure 1 * <br> --- | 1 | |
| A | REVUE DE PHYSIQUE APPLIQUEE, vol. 18, no. 11, novembre 1983, pages 727-730, Orsay, FR; E. DU TREMOLET DE LACHEISSERIE et al.: "An improved capacitance method of measuring thermal expansion and magnetostriction of amorphous ribbons: application to FeNiCr metallic glasses" <br> * Page 727, colonne 1, ligne 16 - colonne 2, ligne 17 * <br> --- | 1 | |
| A | DIGEST OF INTERMAG '86 - INTERNATIONAL MAGNETICS CONFERENCE, Phoenix, Arizona, 14-17 avril 1986, page FD-2, IEEE, New York, US; T. SONODA et al.: "Field and force sensors using amorphous ribbons" <br> * En entier * <br> --- | | |
| A | INSTRUMENTS AND EXPERIMENTAL TECHNIQUES, vol. 25, no. 1, partie 2, 1982, 223-225, Plenum Publishing Corp., New York, US; Z.A. KAZEI et al.: "A capacitance transducer for measuring the magnetostriction of small specimens at 4.2oK" <br> ----- | | |

DOMAINES TECHNIQUES RECHERCHES (Int. Cl.4)

G 01 R

Le présent rapport a été établi pour toutes les revendications

| Lieu de la recherche | Date d'achèvement de la recherche | Examinateur |
|---|---|---|
| LA HAYE | 21-03-1989 | HAASBROEK J.N. |

EPO FORM 1503 03.82 (P0402)